# EUROPEAN PATENT APPLICATION

(11) **EP 4 459 870 A1**
(43) Date of publication of application: **06.11.2024**
(21) Application number: 24173004.3
(22) Date of filing: 29.04.2024
(51) Int. Cl.: H03K 19/003, B64C 25/42, B60T 8/17, B60T 8/88, B60T 17/22

(54) **SINGLE EVENT UPSET PROTECTION**

(30) Priority: 02.05.2023 US 202318310888
(71) Applicant: Goodrich Corporation, Charlotte, NC 28217-4578 (US)
(72) Inventor: GEORGIN, Marc J., Dayton, 45419 (US)
(74) Representative: Dehns

(57) **Abstract**

A single event upset (SEU) mitigation system is disclosed herein. The SEU system includes a trigger circuit configured to receive an input signal, a hold circuit operatively coupled to the trigger circuit and configured to receive a first signal from the trigger circuit, a reset circuit operatively coupled to the hold circuit and configured to output a reset signal in response to receiving one or more hold signals from the hold circuit, and a controller operatively coupled to the reset circuit, the controller configured to reset in response to the reset signal.

## Description

### FIELD

The present disclosure generally relates to aircraft braking system and more particularly to aircraft braking system safety features.

### BACKGROUND

Modem brake control systems employ more complex electronic devices and chips and higher processor capabilities and designs that can be sensitive to single event upsets (SEU's). An SEU usually happens at high altitude where cosmic particles can hit the electronics inside the aircraft and cause, for example, a bit pattern modification in the memory of a processor thereby tending to potentially cause software to execute incorrectly during landing.

### SUMMARY

Disclosed herein is a single event upset mitigation system. The system includes a trigger circuit configured to receive an input signal, a hold circuit operatively coupled to the trigger circuit and configured to receive a first signal from the trigger circuit, a reset circuit operatively coupled to the hold circuit and configured to output a reset signal in response to receiving one or more hold signals from the hold circuit, and a controller operatively coupled to the reset circuit, the controller configured to reset in response to the reset signal.

In various embodiments, the system further includes a watchdog circuit operatively coupled to the reset circuit and the controller, the watchdog circuit configured to receive the reset signal and output a watchdog signal, wherein the controller resets in response to the watchdog signal. In various embodiments, the system further includes a power source and a switch coupled to the power source and the controller, wherein the switch is configured to disconnect and reconnect the power source from the controller in response to the reset signal, causing the controller to reset.

In various embodiments, the switch includes a field effect transistor. In various embodiments, the trigger circuit includes a plurality of trigger circuits, wherein the input signal includes a plurality of input signals and wherein the hold circuit includes a plurality of hold circuits. In various embodiments, the input signal includes at least one of a landing gear handle down signal, a landing gear handle up signal, or a landing gear down lock signal. In various embodiments, the trigger circuit, the hold circuit, and the reset circuit include analog or digital logic components.

Also disclosed herein is an aircraft including a landing gear system including a landing gear assembly, a control for the landing gear assembly, and at least one brake assembly, a brake control unit configured to operate the at least one brake assembly, and a single event upset mitigation system coupled to the landing gear system and the brake control unit. The single event upset mitigation system includes a trigger circuit configured to receive an input signal from the landing gear system, a hold circuit configured to receive a first signal from the trigger circuit, and a reset circuit configured to output a reset signal in response to receiving a hold signal from the hold circuit, wherein the brake control unit resets in response to the reset signal.

In various embodiments, the single event upset mitigation system further includes a watchdog circuit operatively coupled to the reset circuit and the brake control unit, the watchdog circuit configured to receive the reset signal and output a watchdog signal, wherein the brake control unit resets in response to the watchdog signal. In various embodiments, the brake control unit includes a processor having a reset pin and the watchdog circuit outputs the watchdog signal to the reset pin of the processor.

In various embodiments, the single event upset mitigation system further includes a power source and a switch coupled to the power source and the brake control unit, wherein the switch is configured to disconnect and reconnect the power source from the brake control unit in response to the reset signal, causing the brake control unit to reset. In various embodiments, the switch includes a field effect transistor.

In various embodiments, the input signal is received from the control for the landing gear, the input signal including a landing gear handle down signal, a landing gear handle up signal, and a landing gear down lock signal. In various embodiments, the trigger circuit is configured to send the first signal in response to a rising edge of the landing gear handle down signal, a falling edge of the landing gear handle up signal, and a rising edge of the landing gear down lock signal.

Also disclosed herein is a brake system including a brake control unit, one or more brake assemblies configured to receive instructions from the brake control unit, a trigger circuit configured to receive an input signal and output a first signal, a hold circuit configured to receive the first signal and output the first signal for a predetermined time period, and a reset circuit configured to receive the first signal from the hold circuit and output a reset signal to the brake control unit in response to the first signal.

In various embodiments, the input signal includes a plurality of input signals. In various embodiments, the reset circuit is configured to output the reset signal in response to the plurality of input signals being in a predetermined state. In various embodiments, the brake system further includes a watchdog circuit operatively coupled to the reset circuit and the brake control unit, the watchdog circuit configured to receive the reset signal and output a watchdog signal to the brake control unit, wherein the brake control unit resets in response to the watchdog signal.

In various embodiments, the brake system further includes a switch and a power source coupled to the brake control unit through the switch, wherein the switch is configured to disconnect and reconnect the power source from the brake control unit in response to the reset signal, causing the brake control unit to reset. In various embodiments, the switch includes one or more field effect transistors.

The foregoing features and elements may be combined in any combination, without exclusivity, unless expressly indicated herein otherwise. These features and elements as well as the operation of the disclosed embodiments will become more apparent in light of the following description and accompanying drawings.

### BRIEF DESCRIPTION OF THE DRAWINGS

The subject matter of the present disclosure is particularly pointed out and distinctly claimed in the concluding portion of the specification. A more complete understanding of the present disclosure, however, may best be obtained by referring to the following detailed description and claims in connection with the following drawings. While the drawings illustrate various embodiments employing the principles described herein, the drawings do not limit the scope of the claims.
FIG. 1 illustrates an aircraft having multiple landing gear and brakes, in accordance with various embodiments.
FIGS. 2A and 2B illustrate single event upset mitigation systems for landing gear systems in an aircraft, in accordance with various embodiments.
FIGS. 3A and 3B illustrate single event upset mitigation systems for landing gear systems in an aircraft, in accordance with various embodiments.
FIG. 4 illustrates a flow diagram for a method of mitigating single event upset in a landing gear system of an aircraft, in accordance with various embodiments.

### DETAILED DESCRIPTION

The following detailed description of various embodiments herein makes reference to the accompanying drawings, which show various embodiments by way of illustration. While these various embodiments are described in sufficient detail to enable those skilled in the art to practice the disclosure, it should be understood that other embodiments may be realized and that changes may be made without departing from the scope of the disclosure. Thus, the detailed description herein is presented for purposes of illustration only and not of limitation. While these exemplary embodiments are described in sufficient detail to enable those skilled in the art to practice the invention, it should be understood that other embodiments may be realized and that logical, chemical and mechanical changes may be made without departing from the spirit and scope of the invention. For example, the steps recited in any of the method or process descriptions may be executed in any order and are not necessarily limited to the order presented. Furthermore, any reference to singular includes plural embodiments, and any reference to more than one component or step may include a singular embodiment or step. Also, any reference to attached, fixed, connected, or the like may include permanent, removable, temporary, partial, full or any other possible attachment option. Additionally, any reference to without contact (or similar phrases) may also include reduced contact or minimal contact. It should also be understood that unless specifically stated otherwise, references to "a," "an" or "the" may include one or more than one and that reference to an item in the singular may also include the item in the plural. Further, all ranges may include upper and lower values and all ranges and ratio limits disclosed herein may be combined.

Disclosed herein is a robust mitigation system for single event upset (SEUs) aircraft brake control units (BCUs). During typical flight operations there is a non-zero chance that software in the BCUs may be corrupted by cosmic rays (i.e., an SEU) resulting in unreliable results from the BCUs. Accordingly, a system for mitigating SEUs is described herein. In various embodiments, the mitigation system may be implemented exclusively using electronic circuitry that is not controlled by software. That is, the mitigation system may be implemented purely by hardware components. In various embodiments, the mitigation system includes circuitry that resets the power source to the BCU (e.g., the 28V aircraft power source) in response to one or more events during a landing approach. In various embodiments, the mitigation system includes circuitry that commands a watchdog timer circuitry, or watchdog, within the BCU to reset the BCU in response to one or more events during a landing approach. In various embodiments, the circuitry of the mitigation system may be external to the BCU. In various embodiments, the circuitry of the mitigation system may be internal to the BCU. In various embodiments, resetting the BCU clears any SEU or software corruption that may have occurred without any risk to the aircraft or passengers.

In various embodiments, the one or more events may be one or more signals that the BCU receives during the landing approach. In various embodiments, the aircraft (e.g., the cockpit) sends a landing gear handle up signal, a landing gear handle down signal, and a landing gear down lock signal. In various embodiments, the landing gear handle up signal and the landing gear handle down signal may be sent in response to a pilot activating the landing gear (e.g., pulling a landing gear handle to a down position). In various embodiments, the landing gear down lock signal may be sent in response to the landing gear extending fully. In various embodiments, each signal is discrete and provides an indication of the status of the landing gear. In various embodiments, the mitigation system circuitry receives the landing gear handle up signal, the landing gear handle down signal, and the landing gear down lock signal and resets the BCU to clear faults that may have occurred in the software.

As disclosed herein, the mitigation system allows for resetting the BCU in response to a hardware signal and without the use of software. Removing software from the mitigation system reduces or eliminates the chance for a fault in the mitigation system. Accordingly, the mitigation system provides a robust method to reset the BCU during a landing approach, ensuring that the software is executing correctly.

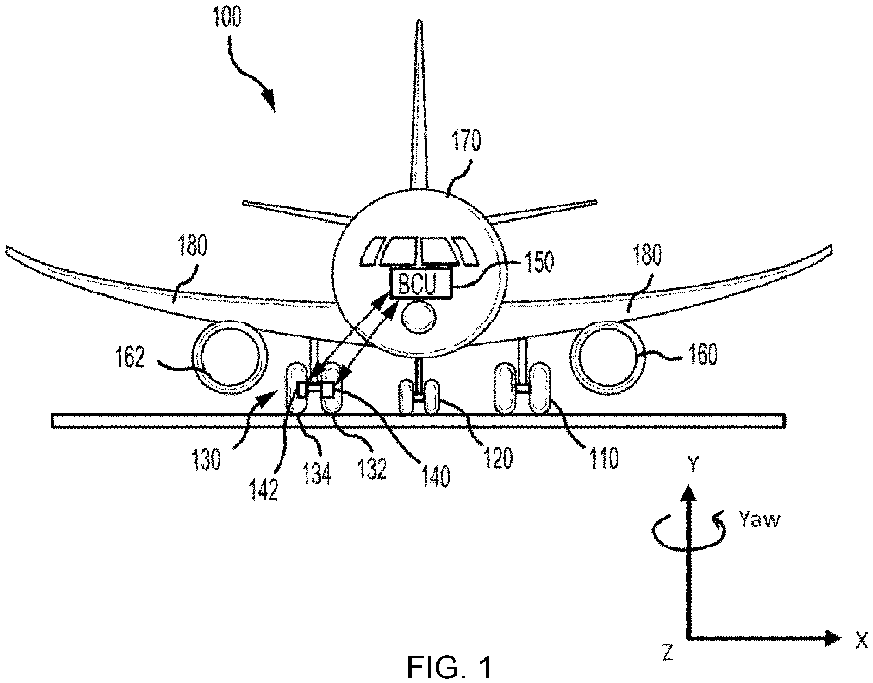

Referring now to FIG. 1, an aircraft 100 including multiple landing gears including a first landing gear 110, a second landing gear 120, and a third landing gear 130 is illustrated, in accordance with various embodiments. Each landing gear may include one or more wheel assemblies. For example, the third landing gear 130 includes an inner wheel assembly 132 and an outer wheel assembly 134.

The aircraft 100 may further include one or more brakes coupled to each wheel assembly. For example, a first brake 140 may be coupled to the inner wheel assembly 132, and a second brake 142 may be coupled to the outer wheel assembly 134. The first brake 140 may apply a braking force to the inner wheel assembly 132 upon receiving a brake command. Similarly, the second brake 142 may apply a braking force to the outer wheel assembly 134 upon receiving a brake command.

The aircraft 100 may further include a brake control unit (BCU) or brake controller 150. The brake controller 150 may include one or more processors and one or more tangible, non-transitory memories and be capable of implementing logic. The processor can be a general purpose processor, a digital signal processor (DSP), an application specific integrated circuit (ASIC), a field programmable gate array (FPGA) or other programmable logic device, discrete gate or transistor logic, discrete hardware components, or any combination thereof. In various embodiments, the brake controller 150 may be specifically designed for controlling operation of aircraft brakes. The brake controller 150 may control operation of the first brake 140 and the second brake 142 under normal operating conditions.

The aircraft 100 further comprises a first gas turbine engine 160 and a second gas turbine engine 162. Although described herein with respect to gas turbine engines 160, 162, the present disclosure is not limited in this regard. For example, electric engines, hydrogen engines, gas turbine engines, or any combination may be within the scope of this disclosure. The first gas turbine engine 160 and the second gas turbine engine 162 are disposed on opposite sides of a fuselage 170 of the aircraft 100. Although illustrated as being coupled to wings 180 of the aircraft 100, the present disclosure is not limited in this regard. For example, gas turbine engines 160, 162 may be coupled to the fuselage 170, in accordance with various embodiments. The gas turbine engines 160, 162 may be controlled by a pilot to generate thrust to accelerate the aircraft 100. In various embodiments, the first gas turbine engine 160 is on a left side of the aircraft 100 and the second gas turbine engine 162 is on a right side of the aircraft 100. Left and right as disclosed herein refer to a direction determined from a center of the fuselage 170 while facing a forward direction (i.e., a direction defined from a tail to a front end of aircraft 100).

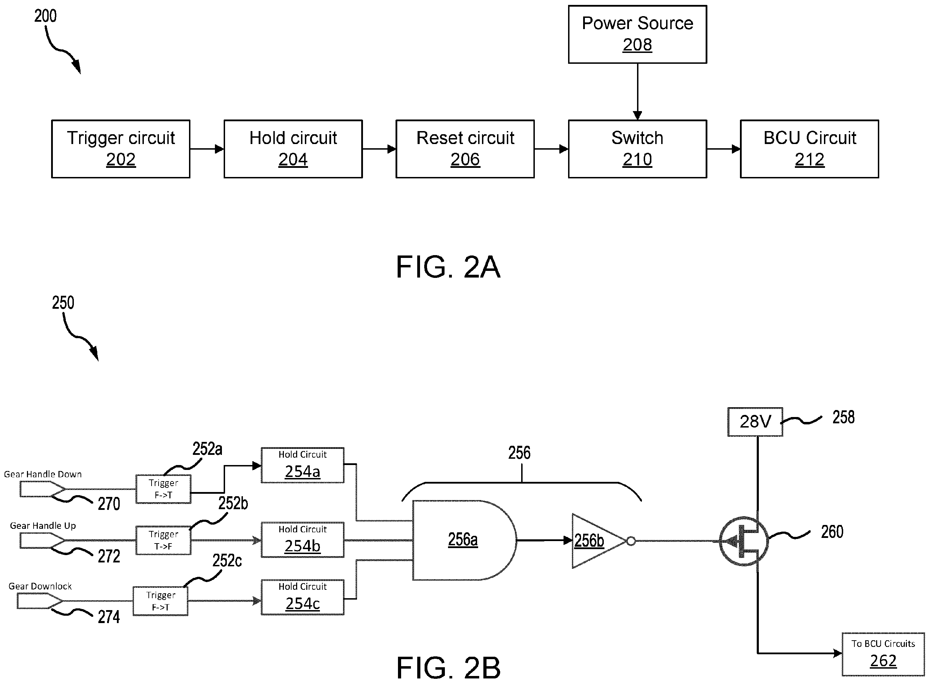

Referring now to FIG. 2A a brake control unit (BCU) error mitigation system 200 is illustrated in accordance with various embodiments. Mitigation system 200 includes a trigger circuit 202, a hold circuit 204, a reset circuit 206, a power source 208, a switch 210, and a brake control unit (BCU) circuit 212. Trigger circuit 202 is coupled to hold circuit 204. Hold circuit 204 is in electronic communication with reset circuit 206. Reset circuit 206 is coupled to switch 210. Switch 210 is coupled to reset circuit 206, power source 208, and BCU circuit 212. Each of the components in mitigation system 200 is completely implemented in hardware and does not use software. In various embodiments, the components of mitigation system 200 may be analog components, digital logic components, or a combination of the two that are not susceptible to a single event upset. It should be appreciated that mitigation system 200 may be implemented with any system and that the descriptions herein are not intended to be limited but are for illustrative purposes and ease of discussion.

BCU circuit 212 is electrically coupled to power source 208 via switch 210. In various embodiments, power source 208 may be an auxiliary power unit of an aircraft (e.g., aircraft 100). In various embodiments, power source 208 may be a 28 V power source that powers the electronics of aircraft 100. Switch 210 is operatively coupled to reset circuit 206, power source 208, and BCU circuit 212. Switch 210 is configured to provide power from power source 208 to BCU circuit 212 (e.g., turn on BCU circuit 212) or to disconnect power source 208 from BCU circuit 212 (e.g., turn off BCU circuit 212) in response to input from reset circuit 206.

Trigger circuit 202 receives an input from aircraft 100 and transmits a signal to hold circuit 204. In various embodiments, the input may be one or more signals received from the cockpit of aircraft 100, including landing gear control signals. In various embodiments, the landing gear control signals may include a landing gear handle down signal, a landing gear handle up signal, and a landing gear down lock signal.

Hold circuit 204 is configured to receive the trigger signal from trigger circuit 202 and hold the trigger signal for a predetermined period of time. In various embodiments, the predetermined period of time may be about 1 second to about 10 seconds, depending on the type of signal received. In various embodiments, the predetermined period of time is about 3 seconds to about 6 seconds. Hold circuit 204 may be any hardware circuit configured to receive and hold a signal for a period of time such as, for example, a sample and hold circuit, a buffer, a buffer amplifier, a latch, or a flip flop, among others.

Reset circuit 206 is configured to receive one or more inputs and provide an output to switch 210 that indicates whether to reset BCU circuit 212 in response to the one or more inputs. The one or more inputs are the one or more signals transmitted by hold circuit 204. The output may be a digital or analog output that provides an indication of whether or not to reset the processor. In various embodiments, a 1 value is a signal to reset BCU circuit 212. In various embodiments, a 0 value is the signal to reset BCU circuit 212.

Referring now to FIG. 2B, a mitigation system 250 is shown, which is an embodiment of mitigation system 200 described above in FIG. 2A. Mitigation system 250 includes similar components to mitigation system 200 including a first trigger circuit 252a, a second trigger circuit 252b, a third trigger circuit 252c, a first hold circuit 254a, a second hold circuit 254b, a third hold circuit 254c, a reset circuit 256, a power source 258, a switch 260, and brake control unit (BCU) circuits 262. Mitigation system 250 further includes a first input 270, a second input 272, and a third input 274.

First input 270 to mitigation system 250 is a landing gear handle down signal. In various embodiments, first input 270 may be True, or "1", in response to the landing gear handle being in a down position (i.e., landing gear extended or extending) and may be False, or "0", in response to the landing gear handle being in an up position (i.e., landing gear retracted or retracting). Second input 272 to mitigation system 250 is a landing gear handle up signal. In various embodiments, second input 272 may be opposite of first input 270. That is, second input 272 may be "False", or "0", in response to the landing gear handle being in a down position (i.e., landing gear extended or extending) and may be "True", or "1", in response to the landing gear handle being in an up position (i.e., landing gear retracted or retracting). Third input 274 to mitigation system 250 is a landing gear down locked signal. In various embodiments, third input 274 may be "True", or "1", in response to the landing gear being extended and locked in the extended position and may be "False", or "0", in response to the landing gear being in any other position than extended and locked (e.g., retracting, retracted, extending, extended and not locked).

First trigger circuit 252a is configured to receive first input 270 and output a first signal to first hold circuit 254a. In various embodiments, the first signal is generally a "False" signal (e.g., a "0" or analog equivalent). However, the first signal changes to a "True" signal (e.g., a "1" or analog equivalent) in response to first input 270 changing from "False" to "True". That is, first trigger circuit 252a detects a rising edge (e.g., transition from "0" to "1") from first input 270. In various embodiments, the first signal returns to "False" after first input 270 reaches steady state (e.g., "True").

Second trigger circuit 252b is configured to receive second input 272 and output a second signal to second hold circuit 254b. In various embodiments, the second signal is generally a "False" signal (e.g., a "0" or analog equivalent). However, the second signal changes to a "True" signal (e.g., a "1" or analog equivalent) in response to second input 272 changing from "True" to "False". That is, second trigger circuit 252b detects a falling edge from second input 272. In various embodiments, the second signal returns to "False" after second input 272 reaches steady state (e.g., "False").

Third trigger circuit 252c is configured to receive third input 274 and output a third signal to third hold circuit 254c. In various embodiments, the third signal is generally a "False" signal (e.g., a "0" or analog equivalent). However, the third signal changes to a "True" signal (e.g., a "1" or analog equivalent) in response to third input 274 changing from "False" to "True". That is, third trigger circuit 252c detects a rising edge from third input 274. In various embodiments, the third signal returns to "False" after third input 274 reaches steady state (e.g., "True").

First hold circuit 254a is configured to receive the first signal from first trigger circuit 252a and hold the received value (e.g., "1" or "0") for a first time duration. In various embodiments, the first time duration may be about 1 second to about 15 seconds, and more specifically, about 5 seconds to about 10 seconds. In various embodiments, the first time duration may be at least the time it takes to extend the landing gear.

Second hold circuit 254b is configured to receive the second signal from second trigger circuit 252b and the hold the received value (e.g., "1" or "0") for a second time duration. In various embodiments, the second time duration may be about 1 second to about 15 seconds, and more specifically, about 5 seconds to about 10 seconds. In various embodiments, the second time duration may be the same as the first time duration. In various embodiments, the second time duration may be at least the time it takes to extend the landing gear.

Third hold circuit 254c is configured to receive the third signal from third trigger circuit 252c and hold the received value (e.g., "1" or "0") for a third time duration. In various embodiments, the third time duration may be about 1 second to about 10 seconds, and more specifically, about 2 seconds to about 5 seconds. In various embodiments, the third time duration may be less than the first time duration and less than the second time duration.

Reset circuit 256, as illustrated in FIG. 2B, includes an AND gate 256a and a NOT buffer 256b. Reset circuit 256, and more specifically, AND gate 256a receives the output of first hold circuit 254a, second hold circuit 254b, and third hold circuit 254c. AND gate 256a then performs a Boolean AND operation on the three inputs so that the output of AND gate 256a is "True" (e.g., "1" or an analog equivalent) if and only if the three inputs are "True". As described above, each hold circuit 254a-254c holds and outputs a received value for a predetermined time duration (i.e., the first time duration, the second time duration, and the third time duration). Accordingly, there is a short time period (e.g., about 1 second to about 10 seconds) wherein the three inputs to AND gate 256a are "True". The output of AND gate 256a is sent to NOT buffer 256b that inverts the value (e.g., changes "1" to "0") and outputs a signal to switch 260. It will be appreciated that is one possible embodiment of reset circuit 206 for use in the mitigation system 250 as illustrated in FIG. 2B and is not intended to be limiting but is for explanation purposes.

Switch 260 connects or disconnects power source 258 to BCU circuits 262 in response to the output from reset circuit 256. In the embodiment illustrated in FIG. 2B, switch 260 disconnects power source 258 from BCU circuits 262 in response to a "0" (or the analog equivalent) received from reset circuit 256. The output of reset circuit 256 returns to a "1" (or the analog equivalent) after a time period as determined by hold circuits 254a-254c thereby connecting power source 258 to BCU circuits 262. In various embodiments, switch 260 may be a field effect transistor (FET) (e.g., a MOSFET) that creates an open circuit in response to the output of reset circuit 256 being "0" and thereby cuts power from BCU circuits. In various embodiments, switch 260 may include more than one FET connected in parallel with reset circuit 256 for redundancy.

As described herein, in accordance with various embodiments, mitigation system 200 and mitigation system 250 provide a robust hardware based brake control unit reset that is triggered by the deployment, or extension, of the landing gear. Mitigation systems 200, 250 reset the brake control unit (BCU) thereby clearing the memory of the BCU, including processors therein, and clear one or more faults that may have occurred in the software during flight with no risk to the aircraft. BCUs are configured to boot quickly to ensure that braking capabilities are available. Typically, BCUs bootup in about 2 seconds when there is no braking activity (e.g., use of the brake pedal) and may bootup in about 500 ms in response to braking activity. Therefore, mitigation systems 200, 250 provide a safe, robust hardware based single event upset protection.

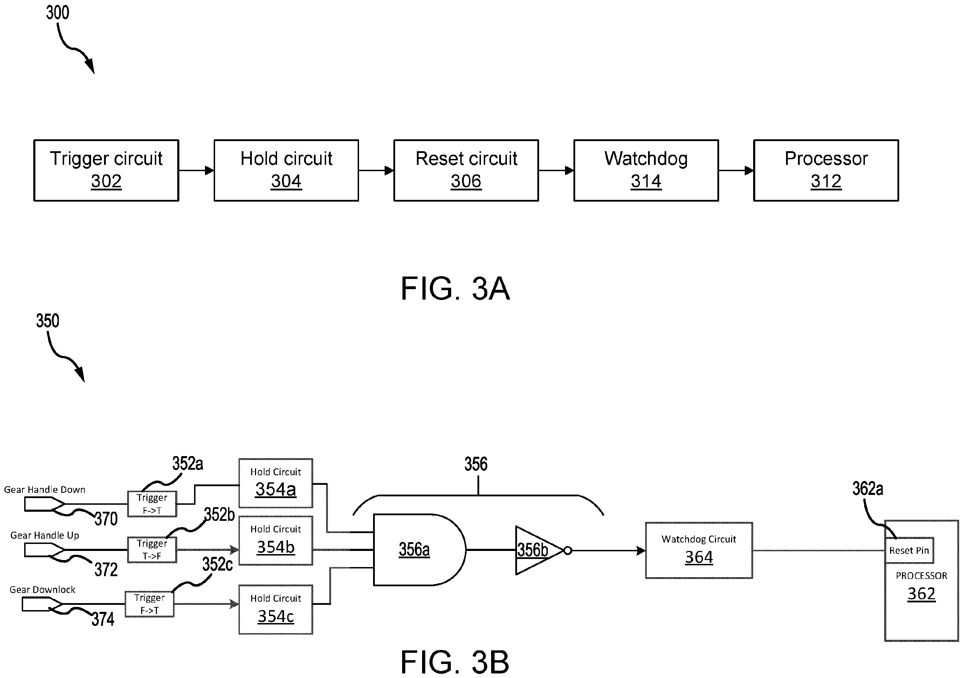

Referring now to FIG. 3A a brake control unit (BCU) error mitigation system 300 is illustrated in accordance with various embodiments. Similar to mitigation system 200 described in FIG. 2A, mitigation system 300 includes a trigger circuit 302, a hold circuit 304, a reset circuit 306, and a processor 312. Mitigation system 300 further includes a watchdog circuit 314. Trigger circuit 302 is coupled to hold circuit 304. Hold circuit 304 is in electronic communication with reset circuit 306. Reset circuit 306 is coupled to watchdog circuit 314. Watchdog circuit 314 is coupled to processor 312. In various embodiments, watchdog circuit 314 may be integrated into processor 312. Each of the components in mitigation system 300 is purely hardware and does not use software. It should be appreciated that mitigation system 300 may be implemented with any system and that the descriptions herein are not intended to be limited but are for illustrative purposes and ease of discussion.

Processor 312 may be part of a brake control unit (BCU) in an aircraft. In various embodiments, processor 312 may be one or more processors in one or more BCUs. Processor 312 receives power from a power source (e.g., a 28 V power source). In various embodiments, processor 312 may include a reset pin or other mechanism for resetting processor 312.

Trigger circuit 302 receives an input from aircraft 100 and transmits a signal to hold circuit 304. In various embodiments, the input may be one or more signals received from the cockpit of aircraft 100, including landing gear control signals. In various embodiments, the landing gear control signals may include a landing gear handle down signal, a landing gear handle up signal, and a landing gear down lock signal.

Hold circuit 304 is configured to receive the trigger signal from trigger circuit 302 and hold the trigger signal for a predetermined period of time. In various embodiments, the predetermined period of time may be about 1 second to about 10 seconds, depending on the type of signal received. In various embodiments, the predetermined period of time is about 3 seconds to about 6 seconds. Hold circuit 304 may be any hardware circuit configured to receive and hold a signal for a period of time such as, for example, a sample and hold circuit, a buffer, a buffer amplifier, a latch, or a flip flop, among others.

Reset circuit 306 is configured to receive one or more inputs from hold circuit and provide an output to watchdog circuit 314 that indicates whether to reset processor 312 in response to the one or more inputs. The one or more inputs are the one or more signals transmitted by hold circuit 304. The output may be a digital or analog output that provides an indication of whether or not to reset the processor. In various embodiments, a 1 value is a signal to reset processor 312. In various embodiments, a 0 value is the signal to reset processor 312.

Watchdog circuit 314 receives the output from reset circuit 306 and sends a signal to processor 312 to reset. In various embodiments, watchdog circuit 314 may be integrated into processor 312. In various embodiments, watchdog circuit 314 may send the reset signal to more than one processor represented by processor 312.

Referring now to FIG. 3B, a mitigation system 350 is shown, which is an embodiment of mitigation system 300 described above in FIG. 3A. Mitigation system 350 includes similar components to mitigation system 300 including a first trigger circuit 352a, a second trigger circuit 352b, a third trigger circuit 352c, a first hold circuit 354a, a second hold circuit 354b, a third hold circuit 354c, a reset circuit 356, an AND gate 356a, a NOT buffer 356b, and a processor 362. Mitigation system 350 further includes a watchdog circuit 364, a first input 370, a second input 372, and a third input 374.

First input 370 to mitigation system 350 is a landing gear handle down signal. In various embodiments, first input 370 may be True, or "1", in response to the landing gear handle being in a down position (i.e., landing gear extended or extending) and may be False, or "0", in response to the landing gear handle being in an up position (i.e., landing gear retracted or retracting). Second input 372 to mitigation system 350 is a landing gear handle up signal. In various embodiments, second input 372 may be opposite of first input 370. That is, second input 372 may be "False", or "0", in response to the landing gear handle being in a down position (i.e., landing gear extended or extending) and may be "True", or "1", in response to the landing gear handle being in an up position (i.e., landing gear retracted or retracting). Third input 374 to mitigation system 350 is a landing gear down locked signal. In various embodiments, third input 374 may be "True", or "1", in response to the landing gear being extended and locked in the extended position and may be "False", or "0", in response to the landing gear being in any other position than extended and locked (e.g., retracting, retracted, extending, extended and not locked).

First trigger circuit 352a is configured to receive first input 370 and output a first signal to first hold circuit 354a. In various embodiments, the first signal is generally a "False" signal (e.g., a "0" or analog equivalent). However, the first signal changes to a "True" signal (e.g., a "1" or analog equivalent) in response to first input 370 changing from "False" to "True". That is, first trigger circuit 352a detects a rising edge from first input 370. In various embodiments, the first signal returns to "False" after first input 370 reaches steady state (e.g., "True").

Second trigger circuit 352b is configured to receive second input 372 and output a second signal to second hold circuit 354b. In various embodiments, the second signal is generally a "False" signal (e.g., a "0" or analog equivalent). However, the second signal changes to a "True" signal (e.g., a "1" or analog equivalent) in response to second input 372 changing from "True" to "False". That is, second trigger circuit 352b detects a falling edge from second input 372. In various embodiments, the second signal returns to "False" after second input 372 reaches steady state (e.g., "False").

Third trigger circuit 352c is configured to receive third input 374 and output a third signal to third hold circuit 354c. In various embodiments, the third signal is generally a "False" signal (e.g., a "0" or analog equivalent). However, the third signal changes to a "True" signal (e.g., a "1" or analog equivalent) in response to third input 374 changing from "False" to "True". That is, third trigger circuit 352c detects a rising edge from third input 374. In various embodiments, the third signal returns to "False" after third input 374 reaches steady state (e.g., "True").

First hold circuit 354a is configured to receive the first signal from first trigger circuit 352a and hold the received value (e.g., "1" or "0") for a first time duration. In various embodiments, the first time duration may be about 1 second to about 15 seconds, and more specifically, about 5 seconds to about 10 seconds. In various embodiments, the first time duration may be at least the time it takes to extend the landing gear.

Second hold circuit 354b is configured to receive the second signal from second trigger circuit 352b and the hold the received value (e.g., "1" or "0") for a second time duration. In various embodiments, the second time duration may be about 1 second to about 15 seconds, and more specifically, about 5 seconds to about 10 seconds. In various embodiments, the second time duration may be the same as the first time duration. In various embodiments, the second time duration may be at least the time it takes to extend the landing gear.

Third hold circuit 354c is configured to receive the third signal from third trigger circuit 352c and hold the received value (e.g., "1" or "0") for a third time duration. In various embodiments, the third time duration may be about 1 second to about 10 seconds, and more specifically, about 3 seconds to about 5 seconds. In various embodiments, the third time duration may be less than the first time duration and less than the second time duration.

Reset circuit 356, as illustrated in FIG. 3B, includes an AND gate 356a and a NOT buffer 356b. Reset circuit 356, and more specifically, AND gate 356a receives the output of first hold circuit 354a, second hold circuit 354b, and third hold circuit 354c. AND gate 356a then performs a Boolean AND operation on the three inputs so that the output of AND gate 356a is "True" (e.g., "1" or an analog equivalent) if and only if the three inputs are "True". As described above, each hold circuit 354a-354c holds and outputs a received value for a predetermined time duration (i.e., the first time duration, the second time duration, and the third time duration). Accordingly, there is a short time period (e.g., about 1 second to about 10 seconds) wherein the three inputs to AND gate 356a are "True". The output of AND gate 356a is sent to NOT buffer 356b that inverts the value (e.g., changes "1" to "0") and outputs a signal to watchdog circuit 364. It will be appreciated that is one possible embodiment of reset circuit 356 for use in the mitigation system 350 as illustrated in FIG. 3B and is not intended to be limiting but is for explanation purposes.

Processor 312 includes a reset pin 362a that is configured to reset processor 362 in response to an input. In various embodiments, the processor 362 may reset in response to a high signal (e.g., "1", 3.3 V, etc.) on reset pint 362a. In various embodiments, the processor 362 may reset in response to a low signal (e.g., "0", 0 V, etc.) on reset pin 362a. In various embodiments, processor 362 include one or more processors configured to implement various logical operations in response to execution of instructions, for example, instructions stored on a non-transitory, tangible, computer-readable medium. The one or more processors can be a general purpose processor, a microprocessor, a microcontroller, a digital signal processor (DSP), an application specific integrated circuit (ASIC), a field programmable gate array (FPGA) or other programmable logic device, discrete or transistor logic, discrete hardware components, or any combination thereof.

Watchdog circuit 364 is configured to receive an input signal from reset circuit 356 and send an output signal to processor 362, and more specifically reset pin 362a, that causes processor 362 to reset. In various embodiments, watchdog circuit 364 may be integrated into processor 362. In various embodiments, watchdog circuit 364 may be coupled to more than one processor and able to reset the more than one processors.

As described herein, in accordance with various embodiments, mitigation system 300 and mitigation system 350 provide a robust hardware based brake control unit reset that is triggered by the deployment, or extension, of the landing gear. Mitigation systems 300, 350 reset one or more processors in a brake control unit (BCU) thereby clearing the memory of the one or more processors in the BCU and thereby clear any fault that may have occurred in the software during flight with no risk to the aircraft. The processors in the BCUs are configured to boot quickly to ensure that braking capabilities are available. Typically, the processors in the BCUs bootup in about 3 seconds when there is no braking activity (e.g., use of the brake pedal) and may bootup in about 500 ms in response to braking activity. Therefore, mitigation systems 300, 350 provide a safe, robust hardware based single event upset protection.

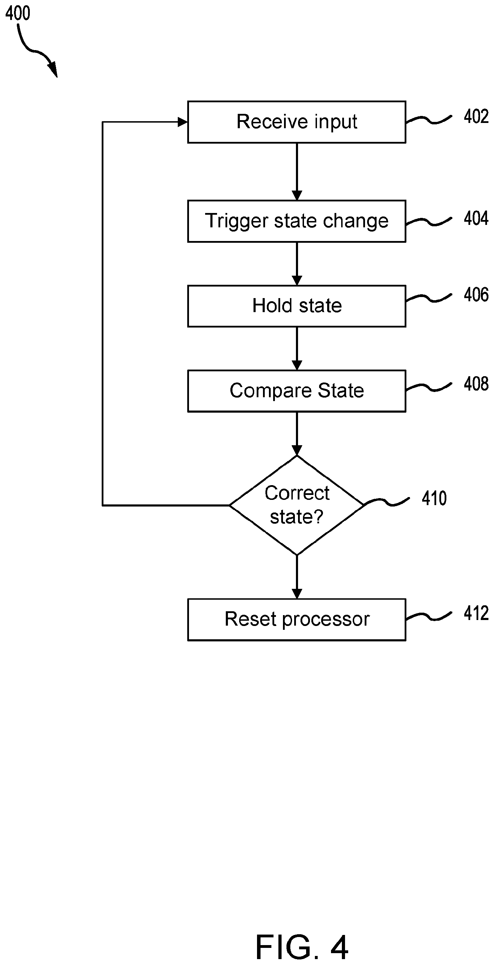

Referring now to FIG. 4, a method 400 for single event upset protection is illustrated, in accordance with various embodiments. In various embodiments, method 400 is performed by hardware components without the use of software. In various embodiments, method 400 is performed by one of mitigation system 200, mitigation system 250, mitigation system 300, or mitigation system 350. At block 402, the mitigation system, e.g., mitigation system 200, mitigation system 250, mitigation system 300, or mitigation system 350, receives an input from the aircraft. In various embodiments, the input may indicate a stat of the landing gear. In various embodiments, the input may include multiple separate inputs. At block 404, the mitigation system triggers a state change in response to the input. At block 406, the mitigation system holds the state for a time period. In various embodiments, the time period may be about 1 second to about 15 seconds. At block 408, the mitigation system compares the state to a desired state (e.g., landing gear extended and locked). At decision block 410, the mitigation system determines whether the current state is the desired, or correct, state. If it is determined that the current state is not the correct state, method 400 returns to block 402. If instead, it is determined that the current state is the correct state, method 400 proceeds to block 412. At block 412, the mitigation system resets a process. In various embodiments, resetting the processor may include disconnecting the processor from power and reconnecting the power. In various embodiments, resetting the processor may include triggering a watchdog circuit to reset the processor, such as by a reset pin.

Benefits, other advantages, and solutions to problems have been described herein with regard to specific embodiments. Furthermore, the connecting lines shown in the various figures contained herein are intended to represent exemplary functional relationships and/or physical couplings between the various elements. It should be noted that many alternative or additional functional relationships or physical connections may be present in a practical system. However, the benefits, advantages, solutions to problems, and any elements that may cause any benefit, advantage, or solution to occur or become more pronounced are not to be construed as critical, required, or essential features or elements of the disclosure. The scope of the disclosure is accordingly to be limited by nothing other than the appended claims, in which reference to an element in the singular is not intended to mean "one and only one" unless explicitly so stated, but rather "one or more." Moreover, where a phrase similar to "at least one of A, B, or C" is used in the claims, it is intended that the phrase be interpreted to mean that A alone may be present In an embodiment, B alone may be present in an embodiment, C alone may be present in an embodiment, or that any combination of the elements A, B and C may be present in a single embodiment; for example, A and B, A and C, B and C, or A and B and C. Different cross-hatching is used throughout the figures to denote different parts but not necessarily to denote the same or different materials.

Systems, methods, and apparatus are provided herein. In the detailed description herein, references to "one embodiment," "an embodiment," "various embodiments," etc., indicate that the embodiment described may include a particular feature, structure, or characteristic, but every embodiment may not necessarily include the particular feature, structure, or characteristic. Moreover, such phrases are not necessarily referring to the same embodiment. Further, when a particular feature, structure, or characteristic is described in connection with an embodiment, it is submitted that it is within the knowledge of one skilled in the art to affect such feature, structure, or characteristic in connection with other embodiments whether or not explicitly described. After reading the description, it will be apparent to one skilled in the relevant art(s) how to implement the disclosure in alternative embodiments.

Numbers, percentages, or other values stated herein are intended to include that value, and also other values that are about or approximately equal to the stated value, as would be appreciated by one of ordinary skill in the art encompassed by various embodiments of the present disclosure. A stated value should therefore be interpreted broadly enough to encompass values that are at least close enough to the stated value to perform a desired function or achieve a desired result. The stated values include at least the variation to be expected in a suitable industrial process, and may include values that are within 5% of a stated value. Additionally, the terms "substantially," "about" or "approximately" as used herein represent an amount close to the stated amount that still performs a desired function or achieves a desired result. For example, the term "substantially," "about" or "approximately" may refer to an amount that is within 5% of a stated amount or value.

Furthermore, no element, component, or method step in the present disclosure is intended to be dedicated to the public regardless of whether the element, component, or method step is explicitly recited in the claims. No claim element herein is to be construed under the provisions of 35 U.S.C. 112(f) unless the element is expressly recited using the phrase "means for." As used herein, the terms "comprises," "comprising," or any other variation thereof, are intended to cover a non-exclusive inclusion, such that a process, method, article, or apparatus that comprises a list of elements does not include only those elements but may include other elements not expressly listed or inherent to such process, method, article, or apparatus.

Finally, it should be understood that any of the above-described concepts can be used alone or in combination with any or all of the other above-described concepts. Although various embodiments have been disclosed and described, one of ordinary skill in this art would recognize that certain modifications would come within the scope of this disclosure. Accordingly, the description is not intended to be exhaustive or to limit the principles described or illustrated herein to any precise form. Many modifications and variations are possible in light of the above teaching.

## Claims

1. A system, comprising:
a trigger circuit configured to receive an input signal;
a hold circuit operatively coupled to the trigger circuit and configured to receive a first signal from the trigger circuit;
a reset circuit operatively coupled to the hold circuit and configured to output a reset signal in response to receiving one or more hold signals from the hold circuit; and
a controller operatively coupled to the reset circuit, the controller configured to reset in response to the reset signal.

2. The system of claim 1, further comprising:
a watchdog circuit operatively coupled to the reset circuit and the controller, the watchdog circuit configured to receive the reset signal and output a watchdog signal, wherein the controller resets in response to the watchdog signal.

3. The system of any preceding claim, further comprising:
a power source; and
a switch coupled to the power source and the controller, wherein the switch is configured to disconnect and reconnect the power source from the controller in response to the reset signal, causing the controller to reset, and optionally wherein the switch includes a field effect transistor.

4. The system of any preceding claim, wherein the trigger circuit includes a plurality of trigger circuits, wherein the input signal includes a plurality of input signals, and wherein the hold circuit includes a plurality of hold circuits.

5. The system of any preceding claim, wherein the input signal includes at least one of a landing gear handle down signal, a landing gear handle up signal, or a landing gear down lock signal.

6. The system of any preceding claim, wherein the trigger circuit, the hold circuit, and the reset circuit include analog or digital logic components.

7. An aircraft, comprising:
a landing gear system including a landing gear assembly, a control for the landing gear assembly, and at least one brake assembly;
a brake control unit configured to operate the at least one brake assembly; and
a single event upset mitigation system coupled to the landing gear system and the brake control unit, the single event upset mitigation system including:
a trigger circuit configured to receive an input signal from the landing gear system;
a hold circuit configured to receive a first signal from the trigger circuit; and
a reset circuit configured to output a reset signal in response to receiving a hold signal from the hold circuit, wherein the brake control unit resets in response to the reset signal.

8. The aircraft of claim 7, wherein the single event upset mitigation system further comprises:
a watchdog circuit operatively coupled to the reset circuit and the brake control unit, the watchdog circuit configured to receive the reset signal and output a watchdog signal, wherein the brake control unit resets in response to the watchdog signal, and optionally wherein the brake control unit includes a processor having a reset pin and the watchdog circuit outputs the watchdog signal to the reset pin of the processor.

9. The aircraft of claim 7 or 8, wherein the single event upset mitigation system further comprises:
a power source; and
a switch coupled to the power source and the brake control unit, wherein the switch is configured to disconnect and reconnect the power source from the brake control unit in response to the reset signal, causing the brake control unit to reset.

10. The aircraft of claim 9, wherein the switch includes a field effect transistor.

11. The aircraft of any of claims 7 to 10 wherein the input signal is received from the control for the landing gear, the input signal including a landing gear handle down signal, a landing gear handle up signal, and a landing gear down lock signal, and optionally wherein the trigger circuit is configured to send the first signal in response to a rising edge of the landing gear handle down signal, a falling edge of the landing gear handle up signal, and a rising edge of the landing gear down lock signal.

12. A brake system, comprising:
a brake control unit;
one or more brake assemblies configured to receive instructions from the brake control unit;
a trigger circuit configured to receive an input signal and output a first signal;
a hold circuit configured to receive the first signal and output the first signal for a predetermined time period; and
a reset circuit configured to receive the first signal from the hold circuit and output a reset signal to the brake control unit in response to the first signal.

13. The brake system of claim 12, wherein the input signal includes a plurality of input signals, and optionally wherein the reset circuit is configured to output the reset signal in response to the plurality of input signals being in a predetermined state.

14. The brake system of claim 12 or 13, further comprising:
a watchdog circuit operatively coupled to the reset circuit and the brake control unit, the watchdog circuit configured to receive the reset signal and output a watchdog signal to the brake control unit, wherein the brake control unit resets in response to the watchdog signal.

15. The brake system of any of claims 12 to 14, further comprising:
a switch; and
a power source coupled to the brake control unit through the switch, wherein the switch is configured to disconnect and reconnect the power source from the brake control unit in response to the reset signal, causing the brake control unit to reset, and optionally wherein the switch includes one or more field effect transistors.
